# EUROPEAN PATENT SPECIFICATION

(11) **EP 2 197 108 B1**
(45) Date of publication and mention of the grant of the patent: **30.01.2013**
(21) Application number: 09724625.0
(22) Date of filing: 06.03.2009
(51) Int. Cl.: H03H 9/64, H01L 41/09, H01L 41/18, H03H 9/145, H03H 9/25, H03H 9/00, H03H 9/02

(54) **ELASTIC WAVE FILTER DEVICE**
ELASTIKWELLENFILTERANORDNUNG
DISPOSITIF DE FILTRAGE D'ONDES ÉLASTIQUES

(30) Priority: 27.03.2008 JP 2008083630
(43) Date of publication of application: 16.06.2010
(73) Proprietor: Murata Manufacturing Co. Ltd., Kyoto 617-8555 (JP)
(72) Inventor: HARUTA, Kazumasa, Nagaokakyo-shi Kyoto 617-8555 (JP)
(74) Representative: Thévenet, Jean-Bruno
(86) International application number: PCT/JP2009/001027
(87) International publication number: WO 2009/119016

(56) References cited:
- EP-A1- 1 763 133
- EP-A2- 1 411 635
- WO-A1-2006/003787
- WO-A1-2006/009021
- DE-A1- 19 818 038
- JP-A- 2004 235 908
- JP-A- 2004 235 908
- JP-A- 2004 282 707
- JP-A- 2007 142 491
- JP-A- 2007 259 430
- US-A1- 2007 290 770

## Description

### DESCRIPTION

### Technical Field

The present invention relates to an acoustic wave filter device including a longitudinally coupled resonator-type acoustic wave filter unit, in which at least three IDTs are formed on a piezoelectric substrate. More particularly, the present invention relates to a longitudinally coupled resonator-type acoustic wave filter device having a balance-unbalance conversion function.

### Background Art

Hitherto, surface acoustic wave filter devices having a balance-unbalance conversion function have been used in band filters of mobile phones, and the like. Furthermore, in recent years, in place of surface acoustic wave filter devices using a surface acoustic wave, boundary acoustic wave filter devices using a boundary acoustic wave have attracted attention. In a case where acoustic wave filter devices, such as surface acoustic wave filter devices or boundary acoustic wave filter devices, have a balance-unbalance conversion function, a balance-unbalance conversion function element called a balun can be omitted. As a consequence, it is possible to reduce the number of parts, and it is possible to decrease the size of mobile phones.

In Patent Document 1 described below, a surface acoustic wave filter device having a balance-unbalance conversion function is disclosed. As shown in Fig. 19, in a surface acoustic wave filter device 1001 disclosed in Patent Document 1, a surface acoustic wave filter element chip 1003 is housed in a package 1002 having an opening 1002a opened upward. In the surface acoustic wave filter element chip 1003, on a piezoelectric substrate 1004, an electrode configuration shown in the figure is formed, and a surface acoustic wave filter having a balance-unbalance conversion function is formed.

That is, a 3-IDT-type longitudinally coupled resonator-type surface acoustic wave filter unit 1008 is connected to an unbalanced terminal 1005 via surface acoustic wave resonators 1006 and 1007. Here, IDTs connected to the unbalanced terminal 1005 are a first IDT 1009 and a third 1011. Then, a second IDT 1010 is arranged in such a manner as to be interposed between the first IDT 1009 and the third IDT 1011. One end of the second IDT 1010 is connected to the first balanced terminal 1012, and the other end thereof is connected to the second balanced terminal 1013.

On the other hand, the other end of the IDT 1009 connected to the unbalanced terminal 1005 is connected to an electrode pad 1015 connected to the ground potential via a ground wiring pattern 1014. Similarly, the other end of the IDT 1011, one end of which is connected to the unbalanced terminal 1005, is connected to an electrode pad 1017 connected to the ground potential through a ground wiring pattern 1016.

On the other hand, in Patent Document 2 described below, an acoustic wave filter device is disclosed in which a first 3-IDT-type longitudinally coupled resonator-type acoustic wave filter unit is connected between an unbalanced terminal and a first balanced terminal, and a second 3-IDT-type longitudinally coupled resonator-type acoustic wave filter unit is connected between an unbalanced terminal and a second balanced terminal, thereby realizing a balance-unbalance conversion function. Here, it is described that by designing ground wiring, the amount of out-of-band attenuation can be reduced.
Patent Document 1: Japanese Unexamined Patent Application Publication No. 2003-124782
Patent Document 2: Japanese Patent No. 3918102

Patent Document DE19818038 describes a longitudinally coupled DMS filter having a balun function and using a V-split IDT structure. The filter's configuration realizes a low ohmic loss, high frequency selective and easy to manufacture DMS balun filter.

### Disclosure of Invention

In the surface acoustic wave filter device 1001 disclosed in Patent Document 1, as described above, by using one longitudinally coupled resonator-type acoustic wave filter unit 1008, a balance-unbalance conversion function is realized. Therefore, not only can a balun be omitted simply, but an electrode configuration for realizing a balance-unbalance conversion function can also be simplified. However, in the surface acoustic wave filter device 1001 disclosed in Patent Document 1, there is a problem in that the amount of attenuation outside the passband is not of a sufficient magnitude.

On the other hand, in Patent Document 2, a configuration is shown in which by designing ground wiring, a lower loss is achieved. However, in Patent Document 2, the configuration in which by designing ground wiring, the amount of out-of-band attenuation is reduced is effective only for a filter device having a specific electrode configuration disclosed in Patent Document 2.

An object of the present invention is to provide an acoustic wave filter device in which the above-described drawbacks of the related art are solved and in which a longitudinally coupled resonator-type acoustic wave filter unit having an IDT connected to an unbalanced terminal and an IDT connected to a balanced terminal is connected between an unbalanced terminal and first and second balanced terminals, and which is capable of increasing the amount of out-of-band attenuation.

According to the present invention, there is provided an acoustic wave filter device including an unbalanced terminal and first and second balanced terminals and having a balance-unbalance conversion function, the acoustic wave filter device including: a piezoelectric substrate; a longitudinally coupled resonator-type acoustic wave filter unit having at least three IDTs and having reflectors arranged on either side of the area in which said IDTs are arranged, the longitudinally coupled resonator-type acoustic wave filter unit being formed on the piezoelectric substrate and being connected between the unbalanced terminal and the first and second balanced terminals; first ground wiring that is formed on the piezoelectric substrate and that has a first end portion and a second end portion, the first end portion being connected to a ground-side end portion of an IDT connected to the first or second balanced terminal among the at least three IDTs; second ground wiring that is formed on the piezoelectric substrate and that has a first end portion and a second end portion, the first end portion being connected to a ground-side end portion of the IDT connected to the unbalanced terminal; and first and second grounding electrode pads that are formed on the piezoelectric substrate, second end portions of the first and second ground wirings being electrically connected to the first and second grounding electrode pads, respectively, wherein the second ground wiring branches into first and second branched wiring parts from the first end portion toward the second end portion thereof, and the first and second branched wiring parts are arranged so as to sandwich an area in which the at least three IDTs and the reflectors are provided.

In an aspect of the acoustic wave filter device according to the present invention, first and second grounding electrode pads are formed from one electrode pad. In this case, the electrode configuration on the piezoelectric substrate can be simplified, and also the acoustic wave filter device can be decreased in size.

In another aspect of the acoustic wave filter device according to the present invention, the first ground wiring has a portion in which the first ground wiring is laminated with a portion of the first branched wiring part with an insulating film therebetween. In this case, since the first branched wiring part and the first ground wiring are laminated with each other, it is possible to decrease the area in which the electrode configuration including the wiring is formed on the piezoelectric substrate, and the acoustic wave filter device can be further decreased in size.

The acoustic wave filter device according to the present invention may be a boundary acoustic wave filter device and may also be a surface acoustic wave filter device. In the case of a boundary acoustic wave filter device, a dielectric laminated on the piezoelectric substrate is further included, and the at least three IDTs are formed between the piezoelectric substrate and the dielectric.

### Advantages

According to the present invention, in a configuration in which a longitudinally coupled resonator-type acoustic wave filter unit having an IDT connected to an unbalanced terminal and IDTs on the balanced side connected to the first and second balanced terminals is connected between the unbalanced terminal and the first and second balanced terminals, second ground wiring connected to the ground-side end portion of the IDT connected to the unbalanced terminal has the first and second branched wiring parts and is arranged in such a manner that the first and second branched wiring parts sandwich an area in which at least three IDTs are provided. As a consequence, differential characteristics between the first and second balanced terminals are improved. Therefore, it is possible to increase the amount of attenuation outside the passband, and it is possible to decrease the loss of the acoustic wave filter device.

### Brief Description of Drawings

[Fig. 1] Fig. 1 is a schematic plan view showing a boundary acoustic wave filter device according to a first embodiment of the present invention.
[Fig. 2] Fig. 2 is a plan view schematically showing the electrode configuration of a one-port-type boundary acoustic wave resonator used in the boundary acoustic wave filter device of the first embodiment.
[Fig. 3] Fig. 3 is a plan view schematically showing the electrode configuration of a 5-IDT-type longitudinally coupled resonator-type boundary acoustic wave filter unit used in the boundary acoustic wave filter device of the first embodiment.
[Fig. 4] Fig. 4 is a schematic plan view showing the circuit configuration of the boundary acoustic wave filter device of the first embodiment of the present invention.
[Fig. 5] Figs. 5(a) and 5(b) are a schematic front sectional view illustrating the three-dimensional structure of the boundary acoustic wave filter device of the first embodiment of the present invention and a partially cutout front sectional view showing the enlarged main portion thereof.
[Fig. 6] Fig. 6 is a schematic plan view illustrating a boundary acoustic wave filter device of a first comparison example, which is provided for comparison, the boundary acoustic wave filter device being not yet publicly known.
[Fig. 7] Fig. 7 is a schematic plan view illustrating a boundary acoustic wave filter device of a second comparison example, which is provided for comparison, the boundary acoustic wave filter device being not yet publicly known.
[Fig. 8] Fig. 8 shows differential characteristics between first and second balanced terminals in the boundary acoustic wave filter devices of the first and second comparison examples.
[Fig. 9] Fig. 9 shows output characteristics from the first balanced terminals in the boundary acoustic wave filter devices of the first and second comparison examples.
[Fig. 10] Fig. 10 shows output characteristics from the second balanced terminals in the boundary acoustic wave filter devices of the first and second comparison examples.
[Fig. 11] Fig. 11 shows differential characteristics between the first and second balanced terminals of the boundary acoustic wave filter devices of the first embodiment and the second comparison example.
[Fig. 12] Fig. 12 shows output characteristics from the first balanced terminals in the boundary acoustic wave filter devices of the first embodiment and the second comparison example.
[Fig. 13] Fig. 13 shows output characteristics from the second balanced terminals in the boundary acoustic wave filter devices of the first embodiment and the second comparison example.
[Fig. 14] Figs. 14(a) and 14(b) are a schematic plan view illustrating the boundary acoustic wave filter device of a second embodiment and a partially cutout sectional view showing the main portion thereof.
[Fig. 15] Figs. 15(a) and 15(b) are a schematic plan view showing the electrode configuration of an boundary acoustic wave filter device according to a modification of the boundary acoustic wave filter device of the second embodiment and a partially cutout sectional view showing the main portion thereof.
[Fig. 16] Fig. 16 shows differential characteristics between the first and second balanced terminals in the boundary acoustic wave filter devices of the second embodiment and the second comparison example.
[Fig. 17] Fig. 17 shows output characteristics from the first balanced terminals in the boundary acoustic wave filter devices of the second embodiment and the second comparison example.
[Fig. 18] Fig. 18 shows output characteristics from the second balanced terminals in the boundary acoustic wave filter devices of the second embodiment and the second comparison example.

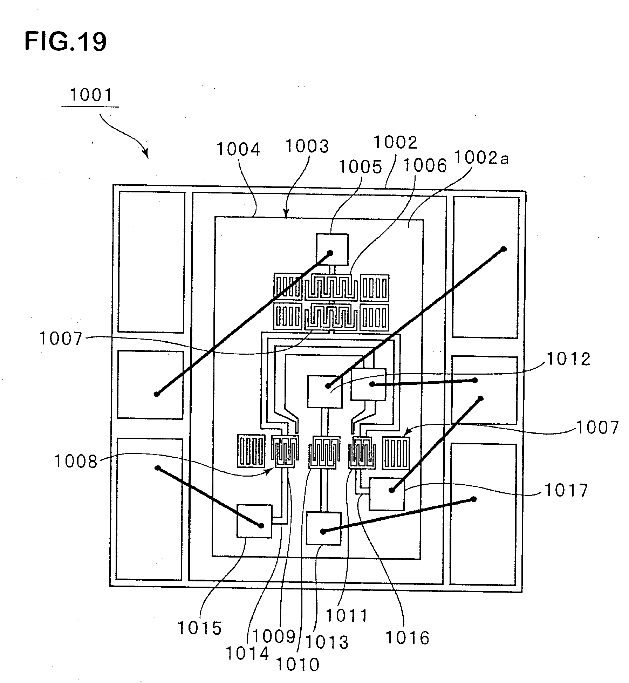

[Fig. 19] Fig. 19 is a plan view illustrating an example of a surface acoustic wave filter device of the related art.

### Reference Numerals

- 1 ...: boundary acoustic wave filter device
- 2 ...: piezoelectric substrate
- 3 ...: unbalanced terminal
- 4 ...: first balanced terminal
- 5 ...: second balanced terminal
- 6 ...: ground terminals
- 7 to 10 ...: bumps
- 11 ...: one-port-type boundary acoustic wave resonator
- 11a ...: IDT
- 11b, 11c ...: reflectors
- 12 ...: longitudinally coupled resonator-type boundary acoustic wave filter unit
- 13 ...: unbalanced-side signal wiring
- 14 ...: first balanced-side signal wiring
- 15 ...: second balanced-side signal wiring
- 16 ...: one-port-type boundary acoustic wave resonator
- 17 ...: first ground wiring
- 18 ...: second ground wiring
- 18a ...: first branched wiring part
- 18b ...: second branched wiring part
- 18c ...: common ground wiring portion
- 21 to 25 ...: first to fifth IDTs
- 26, 27 ...: reflectors
- 31 ...: electrode
- 32 ...: dielectric
- 33 ...: sound absorbing film
- 34, 35 ...: through conductors
- 101 ...: boundary acoustic wave filter device
- 102 ...: insulating layer
- 111 ...: boundary acoustic wave filter device
- 112 ...: insulating layer
- 1101 ...: boundary acoustic wave filter device
- 1102 ...: first ground wiring
- 1103 ...: second ground wiring
- 1104 ...: connection point
- 1105 ...: common ground wiring
- 1201 ...: boundary acoustic wave filter device
- 1202 ...: first ground wiring
- 1203 ...: second ground wiring

### Best Modes for Carrying Out the Invention

Specific embodiments of the present invention will be described below while referring to the drawings, thereby clarifying the present invention.

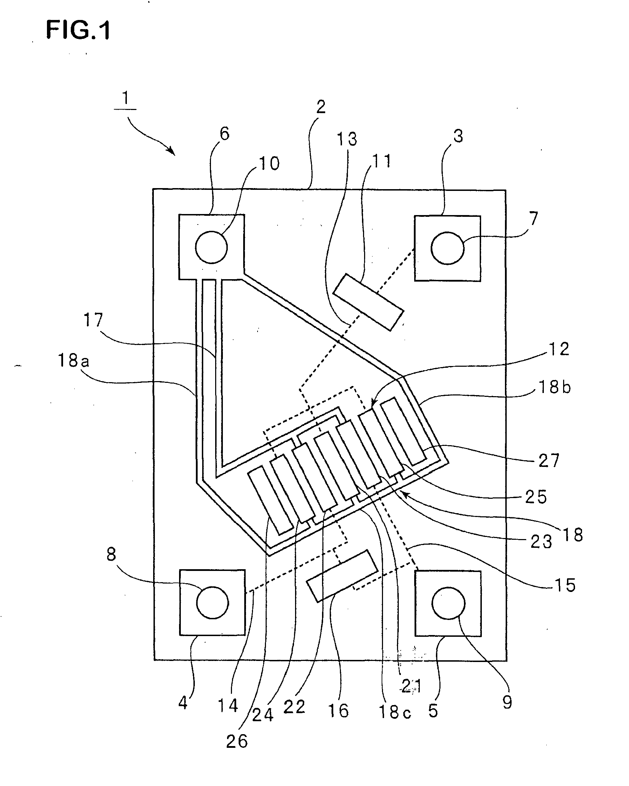

Fig. 1 is a schematic plan view showing a boundary acoustic wave filter device according to a first embodiment of the present invention. In a boundary acoustic wave filter device 1, electrodes that are schematically shown in Fig. 1 are formed on a piezoelectric substrate 2. In the boundary acoustic wave filter device 1, an unbalanced terminal 3, first and second balanced terminals 4 and 5, and a ground terminal 6 are formed on the piezoelectric substrate 2. These terminals are formed from electrode pads, and bumps 7 to 10 are joined on each electrode pad, as indicated by circles. The specific configuration of these terminals and the bumps will be described later.

A 5-IDT-type longitudinally coupled resonator-type boundary acoustic wave filter unit 12 is connected to the unbalanced terminal 3 with a one-port-type boundary acoustic wave resonator 11 therebetween.

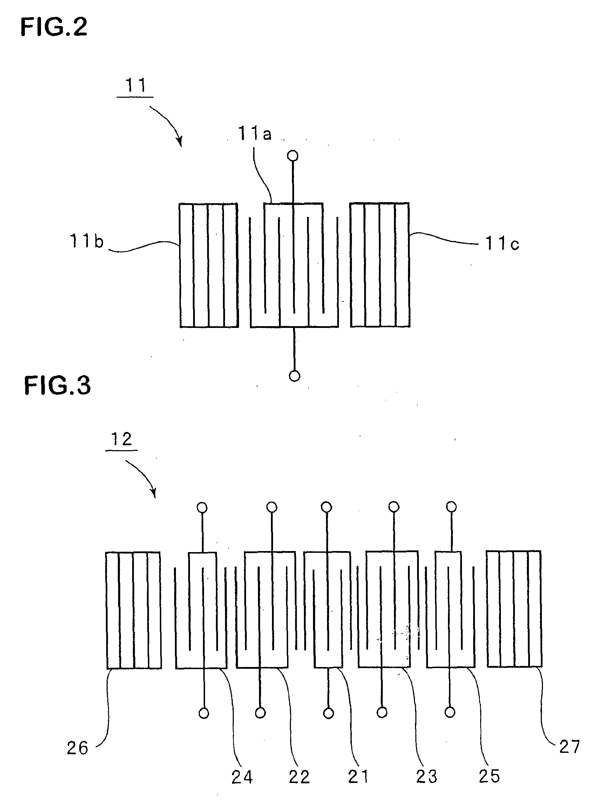

In Fig. 1, the position of the one-port-type boundary acoustic wave resonator 11 is shown by a rectangular block, and the electrode configuration thereof is as shown in Fig. 2. That is, the one-port-type boundary acoustic wave resonator 11 has an IDT 11a, and reflectors 11b and 11c arranged on both sides of the IDT 11a.

On the other hand, the 5-IDT-type longitudinally coupled resonator-type boundary acoustic wave filter unit 12, as indicated by a rectangular block, has a first IDT 21 arranged in the center, a second IDT 22 and a third IDT 23 that are arranged on either side of the first IDT 21 in the boundary acoustic wave propagation direction, a fourth IDT 24 and a fifth IDT 25 that are arranged on either side of the area in which the first to third IDTs 21 to 23 are provided in the boundary wave propagation direction, and reflectors 26 and 27 arranged on either side of the area in which IDTs 21 to 25 are provided in the boundary wave propagation direction. In Fig. 1, these electrodes are shown by rectangular blocks, and the details thereof are as shown in Fig. 3.

In the boundary acoustic wave filter device 1 according to the present embodiment, one end of the first IDT 21, one end of the fourth IDT 24, and one end of the fifth IDT 25 are connected in common and are connected to the unbalanced terminal 3 with the one-port-type boundary acoustic wave resonator 11 therebetween. Therefore, the first IDT 21, the second IDT 24, and the fifth IDT 25 are IDTs on the unbalanced side. Here, a wiring pattern indicated using a dashed line, through which the unbalanced terminal 3 is connected to the common connection point of the IDTs 21, 24, and 25, is assumed to be an unbalanced-side signal wiring 13.

On the other hand, one end of the second IDT 22 is connected to the first balanced terminal 4 through a balanced-side signal wiring 14 indicated using a dashed line. Similarly, one end of the third IDT 23 is electrically connected to the second balanced terminal 5 through a second balanced-side signal wiring 15 indicated using a dashed line. Then, a one-port-type boundary acoustic wave resonator 16 is connected between the first and second balanced-side signal wirings 14 and 15. The one-port-type boundary acoustic wave resonator 16 has the same electrode configuration as the one-port-type boundary acoustic wave resonator 11.

On the other hand, the end portions of the second and thirds IDT 22 and 23 that are connected to the first and second balanced terminals 4 and 5, which are connected to the ground potential, respectively, are connected in common through a first ground wiring 17 and are also connected to the ground terminal 6. That is, the first end portion of the first ground wiring 17 is connected to the ground-side end portions of the IDTs 22 and 23, and the second end portion is connected to the ground terminal 6.

On the other hand, in the present embodiment, the ground-side end portions of the IDTs 21, 24, and 25, which are the IDTs on the unbalanced side, are connected in common, and are connected to the second ground wiring 18.

The feature of the present embodiment is that a second ground wiring 18 has first and second branched wiring parts 18a and 18b, and the first and second branched wiring parts 18a and 18b are arranged so as to sandwich the area in which the IDTs 21 to 25 are provided and so as to be provided on either side of the area and are also electrically connected to the same ground terminal 6.

More specifically, the second ground wiring 18 is connected to the IDTs 21, 24, and 25 on the first end portion side, and is made to branch to the first branched wiring part 18a and the second branched wiring part 18b from the first end portion side toward the second end portion on the opposite side.

In order to clearly define the first and second branched wiring parts 18a and 18b, the ground wiring portion that commonly connect the ground-side end portions of the first IDT 21, the fourth IDT 24, and the fifth IDT 25 is denoted as a common ground wiring portion 18c. The common ground wiring portion 18c is assumed to include the first end portion of the second ground wiring 18 and to refer to the portion from the portion that is connected to the ground-side end portion of the fourth IDT 24 up to the portion connected to the ground-side end portion of the fifth IDT 25. Therefore, the first branched wiring part 18a is provided from one end of the common ground wiring portion 18c to outside the portion in which the reflector 26 is provided, and extends to the ground terminal 6. On the other hand, the second branched wiring part 18b is provided from the other end of the common ground wiring portion 18c to outside the portion in which the reflector 27 is provided and extends to the ground terminal 6. Then, the end portions of the first and second branched wiring parts 18a and 18b, that is, the second end portion of the second ground wiring 18, is connected to the ground terminal 6.

In the present embodiment, since the second ground wiring 18 is formed in the manner described above, it is possible to increase the amount of out-of-band attenuation.

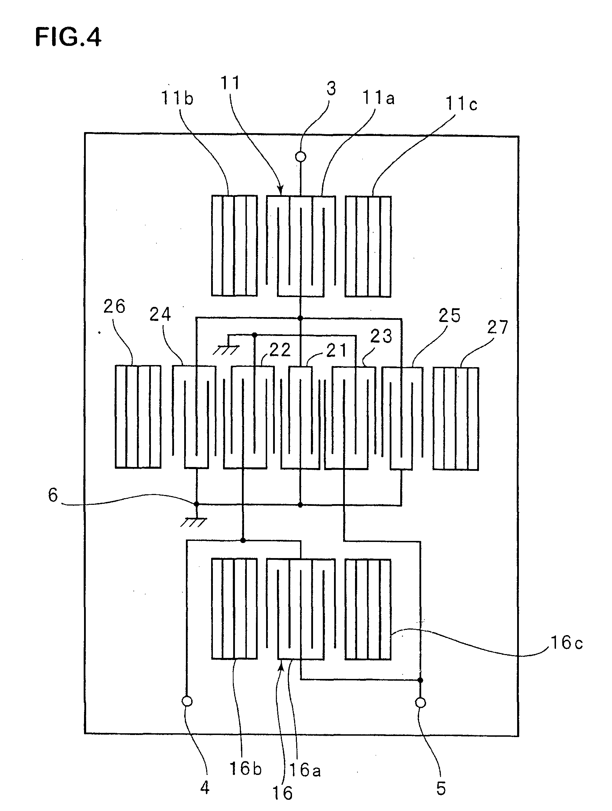

An electrode configuration is formed on the piezoelectric substrate 2. As a result, in the present embodiment, a filter circuit shown in Fig. 4 is formed. That is, an boundary acoustic wave filter device having a balance-unbalance conversion function, to which is connected the 5-IDT-type longitudinally coupled resonator-type boundary acoustic wave filter unit 12 having IDTs connected to an unbalanced terminal between the unbalanced terminal 3 and the first and second balanced terminals 4 and 5, and first and second balanced-side IDTs that are connected to the first and second balanced terminals, respectively, is formed.

The one-port-type boundary acoustic wave resonator 11 needs not necessarily to be provided. However, as a result of providing the boundary acoustic wave resonator 11, it is possible to increase the amount of attenuation in the vicinity of the higher frequency side of the passband. In a similar manner, the one-port-type boundary acoustic wave resonator 16 needs not necessarily to be provided. However, as a result of providing the one-port-type boundary acoustic wave resonator 16, it is possible to increase the amount of attenuation in the vicinity of the lower frequency side of the passband, which is desirable.

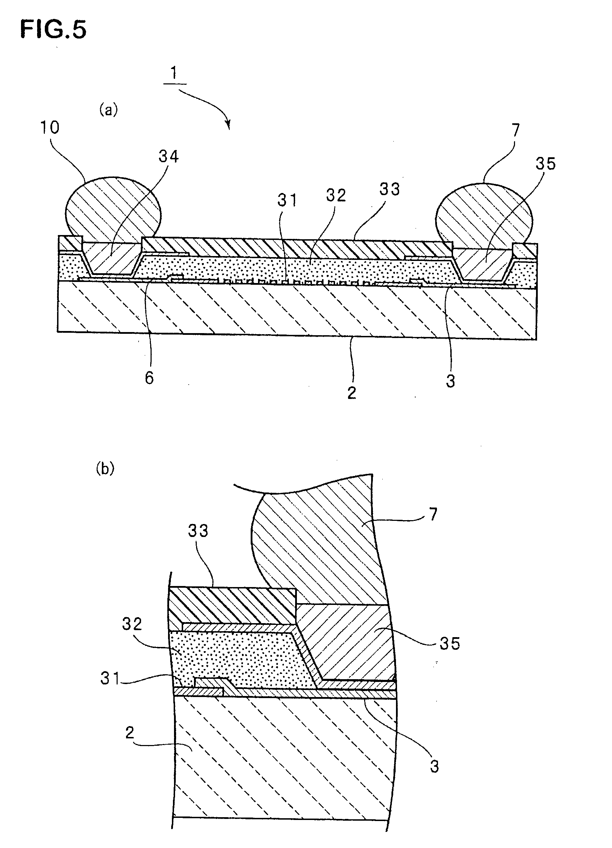

The three-dimensional structure of the boundary acoustic wave filter device 1 according to the present embodiment will be described with reference to Figs. 5(a) and 5(b).

Figs. 5(a) and 5(b) are a front sectional view schematically showing a portion of the boundary acoustic wave filter device 1, and a partially cutout front sectional view showing the enlarged main portion thereof, respectively. In the boundary acoustic wave filter device 1, an electrode 31 shown in Fig. 5(a) is formed on the piezoelectric substrate 2. As the electrode 31, the electrode configuration shown in Figs. 1 and 4 is formed.

Then, in Fig. 5(a), the portion in which the unbalanced terminal 3 and the ground terminal 6 are provided is schematically shown. The ground terminal 6, as shown in the figure, is formed using a grounding electrode pad connected to an electrode 31. In a similar manner, the unbalanced terminal 3 is formed using an electrode pad connected to the electrode 31. Then, in the boundary acoustic wave filter device 1, a dielectric 32 is laminated so as to cover the electrode 31 on the piezoelectric substrate 2. The electrodes including the IDTs 21 to 25 are formed on the interface between the piezoelectric substrate 2 and the dielectric 32. Examples of materials forming the piezoelectric substrate 2 include a piezoelectric single crystal, such as LiTaO₃ or LiNbO₃. Examples of the dielectric 32 include appropriate dielectric materials, such as SiO₂ and SiN.

In the present embodiment, a boundary acoustic wave is propagated by causing the IDTs 21 to 25 formed on the interface between the piezoelectric substrate 2 and the dielectric 32 to be excited.

Additionally, a sound absorbing film 33 is laminated in such a manner as to cover the dielectric 32. The sound absorbing film 33 is formed using an appropriate synthetic resin, glass, or insulating ceramic.

Furthermore, a through hole through which the ground terminal 6 and the unbalanced terminal 3 are exposed is formed so as to go through the sound absorbing film 33 and the dielectric 32. Through conductors 34 and 35 are filled in this through hole. Then, the bump 10 and the bump 7, which are shown in Fig. 1, are formed on the through conductors 34 and 35.

Examples of materials forming the bumps 10 and 7 include appropriate metals, such as solder and Au.

Furthermore, the electrode pads forming the electrode 31 and the terminals formed on the piezoelectric substrate 2, the ground wirings 17 and 18, the through conductors 34 and 35, and the like are made from Al, Cu, Au, Pt, Ti, Ni, Cr, or an alloy thereof. Furthermore, these electrodes and wiring may be formed by a multilayered metal film in which a plurality of metal films are laminated.

In Fig. 1, the unbalanced-side signal wiring 13, the first and second balanced-side signal wirings 14 and 15, and the like, which are indicated using a dashed line, are, in practice, formed by a conductor pattern having a certain degree of width similarly to the first and second ground wirings 17 and 18. In Fig. 1, in order to facilitate illustration and clarify the features, the signal wiring patterns 13, 14, and 15 are schematically shown using a dashed line.

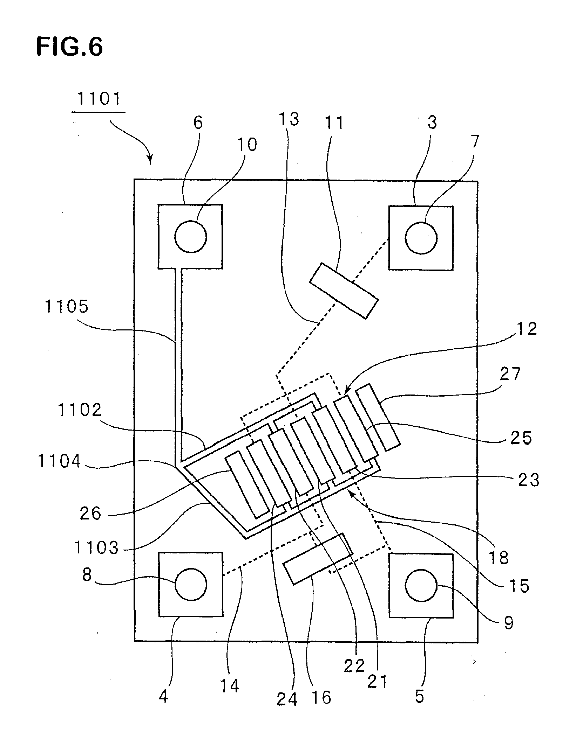

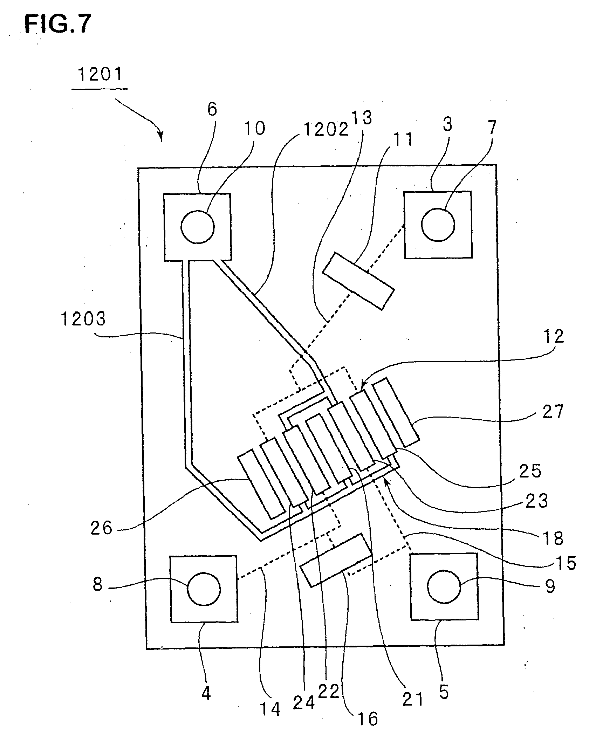

Next, the fact that since the second ground wiring 18 is formed as described above, in the boundary acoustic wave filter device 1 of the first embodiment, the amount of out-of-band attenuation can be increased is clarified by contrasting the boundary acoustic wave filter device 1 with the boundary acoustic wave filter devices 1101 and 1201 of the comparison example, which are shown in Figs. 6 and 7, the boundary acoustic wave filter devices 1101 and 1201 being not yet publicly known.

In the following experimental example, the configuration of the boundary acoustic wave filter unit 12 and the configuration of the one-port-type boundary acoustic wave resonators 11 and 16 are as follows.

Configuration of the boundary acoustic wave filter unit 12
The number of pairs of electrode fingers was set at 17/12.5/11.5/12.5/17 in the order of the fourth IDT 24/second IDT 22/first IDT 21/third IDT 23/fifth IDT 25. The electrode finger cross width in each of the IDTs 21 to 25 was set at 100 µm, and the duty ratio (the arrangement period of the electrode finger width/electrode finger) was set at 0.6.

Furthermore, in the one-port-type boundary acoustic wave resonator 11, the number of pairs of the electrode fingers was set at 55, the electrode finger cross width was set at 100 µm, and the duty ratio was set at 0.6.

In the one-port-type boundary acoustic wave resonator 16, the number of pairs of the electrode fingers was set at 20, the electrode finger cross width was set at 50 µm, and the duty ratio was set at 0.6.

For the electrode material of the filter unit and the resonator, a multilayered metal film in which Ti/Pt/Au/Pt/T/NiCr were laminated in this order from the piezoelectric substrate 2 upward was used. The film thicknesses were set at 10/10/150/10/10/17 (units: nm) in sequence.

Furthermore, with regard to the sound absorbing film 33, a polyimide film of 7 µm was formed.

Furthermore, for the electrode pad portion of the ground terminal 6, and the like, a multilayered metal film in which an AlCu layer of 1600 nm was laminated on a Ti layer having a thickness of 40 nm was used.

The thickness of the dielectric 32 made of SiO₂ was set at 6 µm.

Furthermore, with regard to the ground wirings 17 and 18, signal wiring, and the like, a multilayered metal film in which Ti/AICu/Ti/Pt were laminated in this order from the piezoelectric substrate 2 side toward the upper layers was used. The film thicknesses were set at 20/1000/50/100 (units: nm) in the above-mentioned order. A Ti layer of 40 nm and an AlCu layer of 1600 nm were further laminated on the signal wiring so as to decrease electrical resistance.

Fig. 6 is a schematic plan view showing the electrode configuration of a boundary acoustic wave filter device 1101 of a first comparison example.

The boundary acoustic wave filter device 1101 of the first comparison example is the same as the boundary acoustic wave filter device 1 of the above-described embodiment except that the ground wiring of the longitudinally coupled resonator-type boundary acoustic wave filter unit 12 differs. That is, as shown in Fig. 6, the end portions of the second IDT 22 and the third IDT 23, which are IDTs on the balanced side, the end portions being connected in common, are connected to the ground potential, and first ground wiring 1102 is formed. Furthermore, the end portions of the first IDT 21, the fourth IDT 24, and the fifth IDT 25 on the unbalanced side, the end portions being connected to the ground potential, are connected in common, and are connected to second ground wiring 1103. Here, the first ground wiring 1102 and the second ground wiring 1103 are connected in common at a connection point 1104, and are connected to the ground terminal 6 through a common ground wiring 1105. That is, all the end portions of the first IDT 21 to the fifth IDT 25 on the side connected to the ground potential are connected in common at the connection point 1104, and are connected to the ground terminal 6 through the common ground wiring 1105.

As shown in Fig. 6, by sharing the ground wiring, size reduction can be achieved. However, in the boundary acoustic wave filter device 1101, the amount of out-of-band attenuation was not sufficient.

On the other hand, in an boundary acoustic wave filter device 1201 shown in Fig. 7, first ground wiring 1202 through which the IDTs on the balanced side are connected to the ground terminal 6 is separated from second ground wiring 1203 through which the ground potentials of the first IDT 21, the fourth IDT 24, and the fifth IDT 25 on the unbalanced side are connected in common, the second ground wiring 1203 being connected to the ground terminal 6. That is, on the balanced side and on the unbalanced side, the ground wirings 1202 and 1203 are separated from each other. Regarding the remaining construction, the boundary acoustic wave filter device 1201 is the same as the boundary acoustic wave filter devices 1 and 1101.

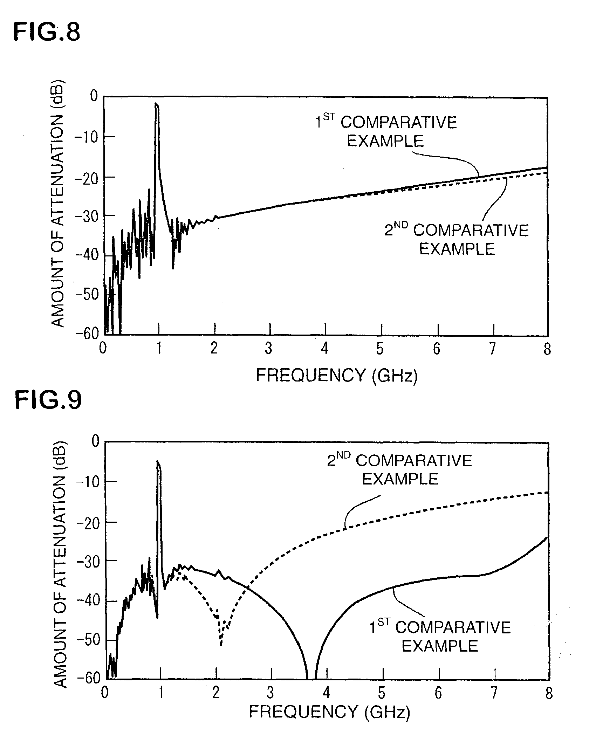

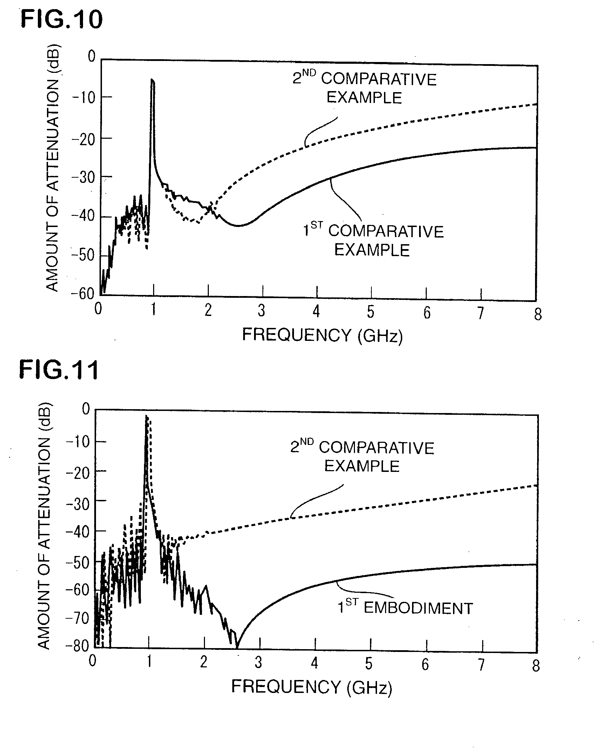

Fig. 8 shows differential characteristics between the first and second balanced terminals in the boundary acoustic wave filter devices of the first and second comparison examples. Fig. 9 shows output characteristics of the first balanced terminals in the boundary acoustic wave filter devices of the first and second comparison examples. Fig. 10 shows output characteristics from the second balanced terminals in the boundary acoustic wave filter devices of the first and second comparison examples. As in the boundary acoustic wave filter device 1201 of the second comparison example, it is ascertained that by separating second ground wiring connected to the unbalanced terminal from the first ground wiring connected to the balanced terminal, the common mode level outside the band is improved. However, as is clear from Figs. 8 to 10, the amount of out-of-band attenuation is not so large regardless of that the second ground wiring is separated or not separated. For example, in the vicinity of 6 GHz, the differential characteristic of the amount of attenuation is limited to approximately 30 dB.

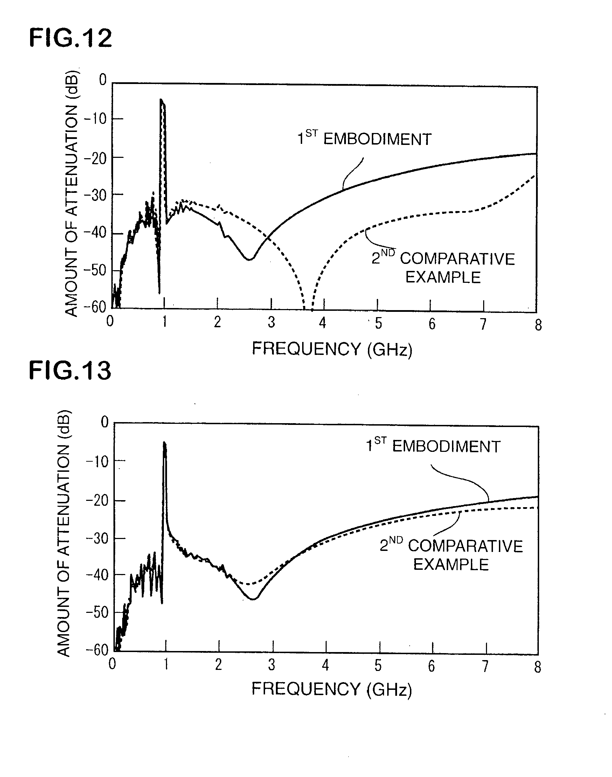

Fig. 11 shows differential characteristics between the first and second balanced terminals in the boundary acoustic wave filter device 1 of the first embodiment and in the boundary acoustic wave filter device 1201 of the second comparison example. Fig. 12 shows output characteristics from the first balanced terminal. Fig. 13 shows output characteristics from the second balanced terminal.

As is clear from Figs. 11 to 13, in particular, as is clear from the differential characteristics of Fig. 11, it can be seen that in the boundary acoustic wave filter device 1 of the first embodiment, the amount of attenuation outside the passband can be greatly improved. For example, at 6 GHz, it can be seen that whereas the amount of attenuation is 30 dB in the second comparison example, in the present embodiment, the amount of attenuation is 50 dB or more, which is increased by 20 dB or more.

That is, it can be seen that by providing the second ground wiring connected to the unbalanced-side IDTs 21 24, and 25 so as to have the branched wiring parts 18a and 18b, the amount of out-of-band attenuation can be improved considerably. This is considered to be attributed from the fact that since the branched wiring parts 18a and 18b are provided so as to extend on either side of the area in which the IDTs 21 to 25 are provided, the parasitic capacitances for the ground wiring become equal, and thus the differential characteristics between the first and second balanced terminals are improved. The differential characteristics are a difference between the output characteristics of the first balanced terminal and the output characteristics of the second balanced terminal. As is clear from Figs. 12 and 13, in the first embodiment, the out-of-band attenuation characteristics at higher frequencies are approximately the same. For this reason, the differential characteristics have been improved. In contrast, in the second comparison example, the out-of-band attenuation characteristics at higher frequencies differ greatly. For this reason, the differential characteristics have worsened. As described above, according to the first embodiment, marked advantages that the amount of out-of-band attenuation is improved greatly by only deforming the pattern of the second ground wiring.

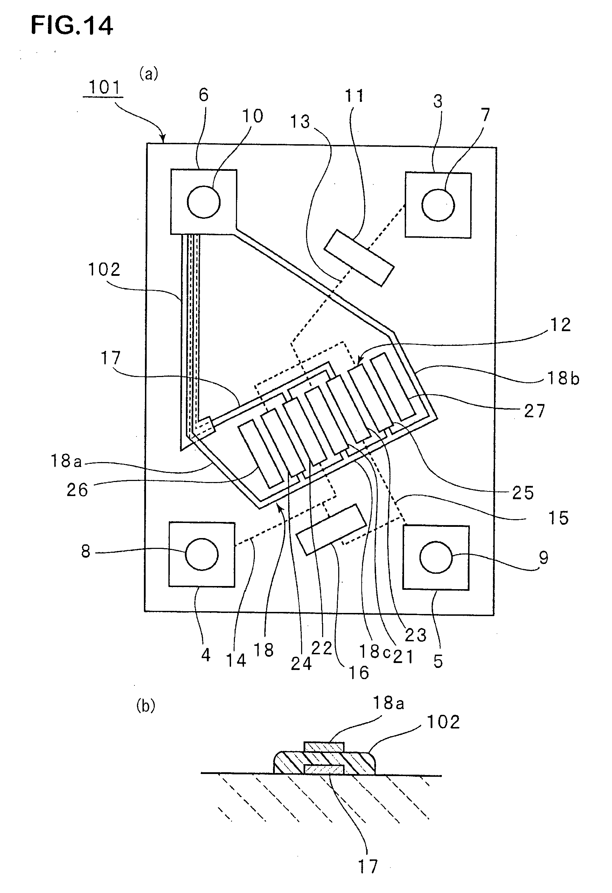

Figs. 14(a) and 14(b) are a schematic plan view of a boundary acoustic wave filter device according to a second embodiment of the present invention, and a partially cutout sectional view showing the main portion thereof.

In the boundary acoustic wave filter device 101 according to the present embodiment, the first ground wiring 17 is arranged so as to overlap a portion of the second ground wiring 18. That is, a portion of the first branched wiring part 18a of the second ground wiring 18 is laminated with the first ground wiring 17 in such a manner as to extend over the first ground wiring 17. However, in order to achieve electrical insulation between them, an insulating layer 102 is formed. That is, the first ground wiring 17 is formed on the piezoelectric substrate 2, the insulating layer 102 is laminated on the first ground wiring 17, and the first branched wiring part 18a of the second ground wiring 18 is connected to the insulating layer 102. As a result, the electrical insulation between the first ground wiring 17 and the first branched wiring part 18a of the second ground wiring 18 is achieved. As described above, the boundary acoustic wave filter device 101 according to the present embodiment is configured to be the same as the boundary acoustic wave filter device 1 of the first embodiment except that a portion of the first branched wiring part 18a is laminated on the first ground wiring 17 with the insulating layer 102 therebetween.

The material forming the insulating layer 102 is not particularly limited. The insulating layer 102 can be formed using an appropriate synthetic resin, such as a polyimide resin, an epoxy resin, or an acryl resin, or an insulating ceramic, such as alumina.

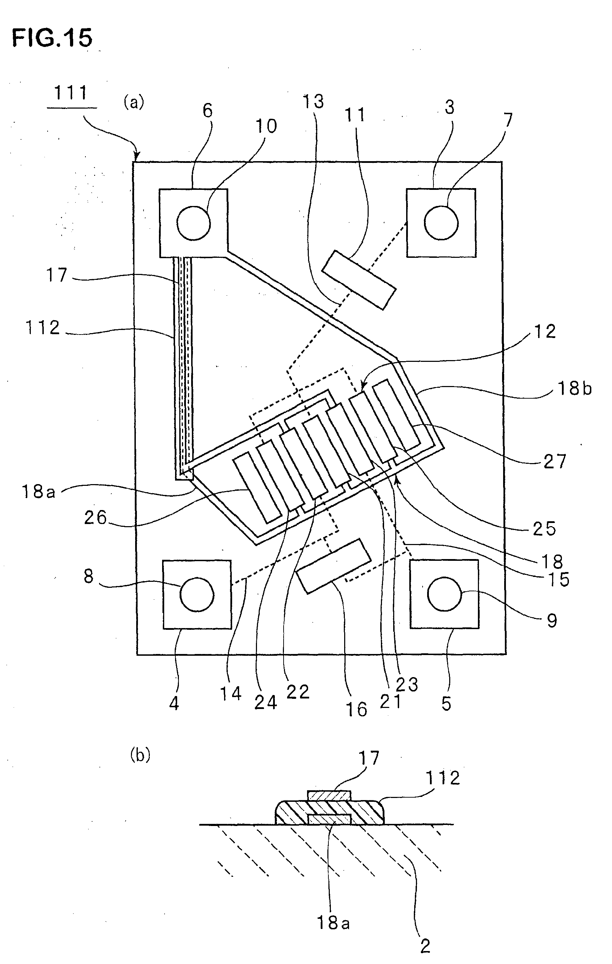

Figs. 15(a) and 15(b) are a schematic plan view showing the boundary acoustic wave filter device 111 according to a modification of the boundary acoustic wave filter device 101 of the second embodiment, and a partially cutout sectional view showing the main portion thereof. Here, conversely to the case of the boundary acoustic wave filter device 101 of the second embodiment, the insulating layer 112 is laminated on the first branched wiring part 18a of the second ground wiring 18, and the first ground wiring 17 is laminated on the insulating layer 112. As described above, in a case where the first ground wiring 17 is laminated with a portion of the first branched wiring part 18a, either of them may be positioned below the other.

In the boundary acoustic wave filter device 101 of the second embodiment and the boundary acoustic wave filter device 111 of the modification, since the first ground wiring 17 is laminated with the second branched wiring part of the second ground wiring 18, the density at which the electrode pattern is formed can be increased, thereby furthering a decrease in size.

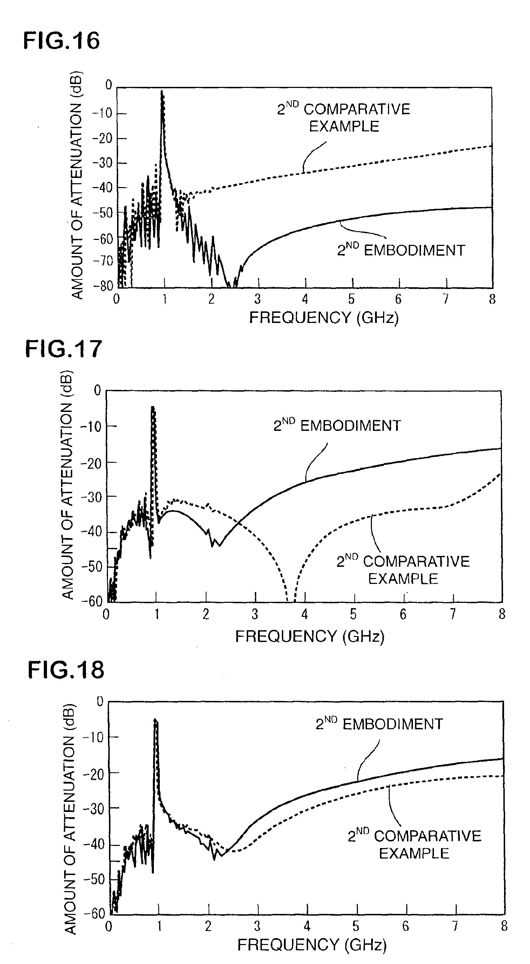

In a case where the first ground wiring 17 is laminated with a portion of the second ground wiring 18 with the insulating layers 102 and 112 therebetween, there is a risk that characteristics may deteriorate due to the capacitance between them. However, in the boundary acoustic wave filter device 101 of the second embodiment and the boundary acoustic wave filter device 111 of the modification, also, the differential characteristics can be greatly improved when compared to the boundary acoustic wave filter device 1201 of the second comparison example. This is shown in Figs. 16 to 18.

Fig. 16 shows differential characteristics between the first and second balanced terminals in the boundary acoustic wave filter device 101 of the second embodiment and the boundary acoustic wave filter device 1201 of the second comparison example. Fig. 17 shows output characteristics from the first balanced terminal. Fig. 18 shows output characteristics from the second balanced terminal. The solid line indicates a result of the second embodiment, and the dashed line indicates a result of the second comparison example.

As is clear from Fig. 16 to 18, in particular, as is clear from the differential characteristics of Fig. 16, also, in the second embodiment, it can be seen that the amount of out-of-passband attenuation can be greatly improved when compared to the second comparison example. That is, it can be seen that, in the frequency band of 6 GHz, also, in the second embodiment, the amount of attenuation can be improved by 30 dB or more when compared to the second comparison example. Therefore, the amount of out-of-passband attenuation can be increased while achieving a decrease in size.

In the first and second embodiments and the modification that have been described above, a boundary acoustic wave filter device has been described. In addition, the present invention can be applied to not only a boundary acoustic wave filter device, but also to a surface acoustic wave filter device using a surface acoustic wave. That is, a surface acoustic wave filter device having an identical configuration can be formed by forming the entire electrode configuration shown in Fig. 1 on a piezoelectric substrate without forming ground wiring on a dielectric.

Therefore, it should be pointed out that Fig. 1 can show a piezoelectric substrate and an electrode configuration for a surface acoustic wave filter device.

Furthermore, in the boundary acoustic wave filter device 1 of the above-described embodiment, five IDTs 21 to 25 are arranged. In addition, the present invention can be widely applied to a boundary acoustic wave filter device including a longitudinally coupled resonator-type boundary acoustic wave filter unit having three or more odd-numbered IDTs.

That is, the present invention can be widely applied to an acoustic wave filter device to which a longitudinally coupled resonator-type acoustic wave filter unit having at least three IDTs in such a manner as to have an IDT connected to an unbalanced terminal and IDTs connected to first and second balanced terminals among at least three IDTs between the unbalanced terminal and the first and second balanced terminals. The acoustic wave filter device disclosed in Patent Document 2, in which a first longitudinally coupled resonator-type acoustic wave filter unit is connected between an unbalanced terminal and a first balanced terminal, and a second longitudinally coupled resonator-type acoustic wave filter is connected between an unbalanced terminal and a second balanced terminal completely differs in terms of the electrode configuration that realizes a balance-unbalance conversion function from the acoustic wave filter device as the target of the present invention. Therefore, it should be pointed out that these are not similar.

## Claims

1. An acoustic wave filter device (1) including an unbalanced terminal (3) and first and second balanced terminals (4,5) and having a balance-unbalance conversion function, the acoustic wave filter device comprising:
a piezoelectric substrate (2);
a longitudinally coupled resonator-type acoustic wave filter unit (12) having at least three IDTs (21-25) and having reflectors arranged on either side of the area in which said IDTs are arranged, the longitudinally coupled resonator-type acoustic wave filter unit being formed on the piezoelectric substrate and being connected between the unbalanced terminal (3) and the first and second balanced terminals (4,5);
first ground wiring (17) that is formed on the piezoelectric substrate and that has a first end portion and a second end portion, the first end portion being connected to a ground-side end portion of an IDT (22,23) connected to the first or second balanced terminal (4,5) among the at least three IDTs;
second ground wiring (18) that is formed on the piezoelectric substrate and that has a first end portion and a second end portion, the first end portion being connected to a ground-side end portion of an IDT (21,24,25) connected to the unbalanced terminal (3); and
first and second grounding electrode pads that are formed on the piezoelectric substrate, the second end portions of the first and second ground wirings (17,18) being electrically connected to the first and second grounding electrode pads, respectively,
wherein the second ground wiring (18) branches into first and second branched wiring parts (18a,18b) from the first end portion toward the second end portion thereof, and the first and second branched wiring parts (18a,18b) are arranged so as to sandwich an area in which the at least three IDTs (21-25) and the reflectors are provided.

2. The acoustic wave filter device (1) according to Claim 1, wherein the first and second grounding electrode pads are formed from one electrode pad (6).

3. The acoustic wave filter device (101/111) according to one of Claims 1 and 2, wherein the first ground wiring (17) has a portion that is laminated with a portion of the first branched wiring part (18a) with an insulating film (102/112) therebetween.

4. The acoustic wave filter device (1) according to any one of Claims 1 to 3, further comprising a dielectric (32) laminated on the piezoelectric substrate (2), wherein the acoustic wave filter device is an boundary acoustic wave filter device in which at least three IDTs (21-25) are formed between the piezoelectric substrate (2) and the dielectric (32).

5. The acoustic wave filter device (1) according to any one of Claims 1 to 3, wherein the acoustic wave filter device is a surface acoustic wave filter device.

## Patentansprüche

1. Akustische Wellenfiltervorrichtung (1), umfassend einen unsymmetrischen Anschluß (3) und erste und zweite symmetrische Anschlüsse (4, 5) sowie eine Symmetrisch-zu-unsymmetrisch-Konvertierungsfunktion aufweisend, wobei die akustische Wellenfiltervorrichtung umfaßt:
ein piezoelektrisches Substrat (2),
eine längs gekoppelte, resonatorartige akustische Wellenfiltereinheit (12), die wenigstens drei IDTs (21-25) aufweist und die Reflektoren aufweist, die auf jeder Seite des Bereiches angeordnet sind, in dem die IDTs angeordnet sind, wobei die längs gekoppelte, resonatorartige akustische Wellenfiltereinheit auf dem piezoelektrischen Substrat ausgebildet ist und zwischen den unsymmetrischen Anschluß (3) und die ersten und zweiten symmetrischen Anschlüsse (4, 5) geschaltet ist,
ein erstes Erdungskabel (17), das auf dem piezoelektrischen Substrat ausgebildet ist und das einen ersten Endabschnitt und einen zweiten Endabschnitt aufweist, wobei der erste Endabschnitt mit einem erdungsseitigen Endabschnitt einer IDT (22, 23), die mit dem ersten oder zweiten symmetrischen Anschluß (4, 5) unter den wenigstens drei IDTs verbunden ist,
ein zweites Erdungskabel (18), das auf dem piezoelektrischen Substrat ausgebildet ist und einen ersten Endabschnitt und einen zweiten Endabschnitt aufweist, wobei der erste Endabschnitt mit einem erdungsseitigen Endabschnitt einer IDT (21, 24, 25), der mit dem unsymmetrischen Anschluß (3) verbunden ist, verbunden ist, und
erste und zweite Erdungselektrodenpads, die auf dem piezoelektrischen Substrat ausgebildet sind, wobei die zweiten Endabschnitte der ersten und zweiten Erdungskabel (17, 18) jeweils elektrisch mit den ersten und zweiten Erdungselektrodenpads verbunden sind,
wobei das zweite Erdungskabel (18) sich in erste und zweite verzweigte Kabelabschnitte (18a, 18b) aus dem ersten Endabschnitt in Richtung des zweiten Endabschnittes davon verzweigt, und die ersten und zweiten verzweigten Kabelabschnitte (18a, 18b) so angeordnet sind, daß sie ein Bereich, in dem die wenigstens drei IDTs (21-25) und die Reflektoren vorgesehen sind, umschließen.

2. Akustische Wellenfiltervorrichtung (1) nach Anspruch 1, wobei die ersten und zweiten Erdungselektrodenpads aus einem Elektrodenpad (6) ausgebildet sind.

3. Akustische Wellenfiltervorrichtung (101/111) nach einem der Ansprüche 1 und 2, wobei das erste Erdungskabel (17) einen Abschnitt aufweist, der mit einem Abschnitt des ersten verzweigten Kabelabschnittes (18a) mit einem Isolationsfilm (102/112) dazwischen laminiert ist.

4. Akustische Wellenfiltervorrichtung (1) nach einem der Ansprüche 1 bis 3, ferner umfassend ein Dielektrikum (32), das auf das piezoelektrische Substrat (2) laminiert ist, wobei die akustische Wellenfiltervorrichtung eine akustische Grenzwellenfiltervorrichtung ist, in der wenigstens drei IDTs (21-25) zwischen dem piezoelektrischen Substrat (2) und dem Dielektrikum (32) ausgebildet sind.

5. Akustische Wellenfiltervorrichtung (1) nach einem der Ansprüche 1 bis 3, wobei die akustische Wellenfiltervorrichtung eine Oberflächenwellenfiltervorrichtung ist.

## Revendications

1. Dispositif de filtrage à ondes acoustiques (1) comprenant une borne non équilibrée (3) et des première et seconde bornes équilibrées (4, 5) et ayant une fonction de conversion d'équilibre-déséquilibre, le dispositif de filtrage à ondes acoustiques comprenant :
un substrat piézoélectrique (2) ;
une unité de filtrage à ondes acoustiques de type résonateur (12) couplée de manière longitudinale, ayant au moins trois IDT (21-25) et ayant des réflecteurs agencés de chaque côté de la zone dans laquelle lesdits IDT sont agencés, l'unité de filtrage à ondes acoustiques de type résonateur couplée de manière longitudinale étant formée sur le substrat piézoélectrique et étant raccordée entre la borne non équilibrée (3) et les première et seconde bornes équilibrées (4, 5) ;
un premier câblage de mise à la terre (17) qui est formé sur le substrat piézoélectrique et qui a une première partie d'extrémité et une seconde partie d'extrémité, la première partie d'extrémité étant raccordée à une partie d'extrémité du côté de terre d'un IDT (22, 23) raccordé à la première ou à la seconde borne équilibrée (4, 5) parmi les au moins trois IDT ;
un second câblage de mise à la terre (18) qui est formé sur le substrat piézoélectrique et qui a une première partie d'extrémité et une seconde partie d'extrémité, la première partie d'extrémité étant raccordée à une partie d'extrémité du côté de terre d'un IDT (21, 24, 25) raccordé à la borne non équilibrée (3) ; et
des premier et second plots d'électrode de terre qui sont formés sur le substrat piézoélectrique, les secondes parties d'extrémité des premier et second câblages de mise à la terre (17, 18) étant électriquement raccordées aux premier et second plots d'électrode de terre, respectivement,
dans lequel le second câblage de mise à la terre (18) se ramifie en première et seconde parties de câblage ramifiées (18a, 18b), de la première partie d'extrémité vers sa seconde partie d'extrémité, et les première et seconde parties de câblage ramifiées (18a, 18b) sont agencées pour prendre en sandwich une zone dans laquelle les au moins trois IDT (21-25) et les réflecteurs sont prévus.

2. Dispositif de filtrage à ondes acoustiques (1) selon la revendication 1, dans lequel les premier et second plots d'électrode de terre sont formés d'un plot d'électrode (6).

3. Dispositif de filtrage à ondes acoustiques (101/111) selon l'une des revendications 1 et 2, dans lequel le premier câblage de mise à la terre (17) a une partie qui est stratifiée avec une partie de la première partie de câblage ramifiée (18a), avec un film isolant (102/112) entre elles.

4. Dispositif de filtrage à ondes acoustiques (1) selon l'une quelconque des revendications 1 à 3, comprenant en outre un diélectrique (32) stratifié sur le substrat piézoélectrique (2), dans lequel le dispositif de filtrage à ondes acoustiques est un dispositif de filtrage à ondes acoustiques limites dans lequel au moins trois IDT (21-25) sont formés entre le substrat piézoélectrique (2) et le diélectrique (32).

5. Dispositif de filtrage à ondes acoustiques (1) selon l'une quelconque des revendications 1 à 3, dans lequel le dispositif de filtrage à ondes acoustiques est un dispositif de filtrage à ondes acoustiques de surface.
